# EUROPEAN PATENT APPLICATION

(11) **EP 4 266 516 A1**
(43) Date of publication of application: **25.10.2023**
(21) Application number: 21906170.2
(22) Date of filing: 29.10.2021
(51) Int. Cl.: H01S 5/183, H01S 5/11

(54) **PHOTONIC CRYSTAL SURFACE EMISSION LASER AND METHOD FOR MANUFACTURING SAME**

(30) Priority: 18.12.2020 JP 2020210275
(71) Applicant: SUMITOMO ELECTRIC INDUSTRIES, LTD., Osaka-shi, Osaka 541-0041 (JP); Kyoto University, Kyoto-shi, Kyoto 606-8501 (JP)
(72) Inventor: KONO, Naoya, Osaka-shi, Osaka 541-0041 (JP); ITO, Yuki, Osaka-shi, Osaka 541-0041 (JP); FUJIWARA, Naoki, Osaka-shi, Osaka 541-0041 (JP); NODA, Susumu, Kyoto-shi, Kyoto 606-8501 (JP); INOUE, Takuya, Kyoto-shi, Kyoto 606-8501 (JP); DE ZOYSA, Menaka, Kyoto-shi, Kyoto 606-8501 (JP); ISHIZAKI, Kenji, Kyoto-shi, Kyoto 606-8501 (JP)
(74) Representative: Grünecker Patent- und Rechtsanwälte PartG mbB
(86) International application number: PCT/JP2021/040130
(87) International publication number: WO 2022/130806

(57) **Abstract**

A photonic-crystal surface emitting laser includes a first semiconductor layer, a photonic crystal layer having a refractive index higher than a refractive index of the first semiconductor layer and provided on the first semiconductor layer, and an active layer provided opposite to the first semiconductor layer with respect to the photonic crystal layer. The photonic crystal layer has a first region and a plurality of second regions each having a refractive index different from a refractive index of the first region and periodically disposed in the first region in a plane of the photonic crystal layer. The second regions extend from the photonic crystal layer to the first semiconductor layer.

## Description

### TECHNICAL FIELD

The present disclosure relates to a photonic-crystal surface emitting laser and manufacturing method thereof.

### BACKGROUND

A photonic-crystal surface emitting laser (PCSEL) in which a photonic-crystal and an active layer having an optical gain are stacked is used (PTLs 1 to 3 and the like). The photonic-crystal includes a periodic structure having a refractive index different from that of the base material. By diffracting light in a plane of the photonic-crystal, light oscillates at a wavelength based on the period and is emitted in the normal direction of the plane. Since the resonator is spread out in a plane, the PCSEL is superior to the edgeemitting laser in single mode operation and high power output.

### PRIOR ART DOCUMENT

### PATENT LITERATURE

PTL 1: Japanese Unexamined Patent Application Publication No. 2007-180120
PTL 2: Japanese Unexamined Patent Application Publication No. 2008-243962
PTL 3: International Publication Pamphlet WO 2017/150387

### SUMMARY

### [Problems to be Solved by the Invention]

In order to reduce power consumption, the PCSEL may be reduced in size and a threshold current may be reduced. However, when the size is reduced, the coupling efficiency of the photonic crystal layer is reduced, and the characteristics of the PCSEL may be deteriorated. Therefore, it is an object of the present disclosure to provide a photonic-crystal surface emitting laser and a method of manufacturing the photonic-crystal surface emitting laser capable of suppressing deterioration of characteristics.

### [Means for solving the problem]

A photonic-crystal surface emitting laser according to the present disclosure includes a first semiconductor layer, a photonic crystal layer having a refractive index higher than a refractive index of the first semiconductor layer and provided on the first semiconductor layer, and an active layer provided opposite to the first semiconductor layer with respect to the photonic crystal layer. The photonic crystal layer has a first region and a plurality of second regions each having a refractive index different from a refractive index of the first region and periodically disposed in the first region in a plane of the photonic crystal layer. The second regions extend from the photonic crystal layer to the first semiconductor layer.

A method of manufacturing a photonic-crystal surface emitting laser according to the present disclosure includes forming a photonic crystal layer on a first semiconductor layer, the photonic crystal layer having a refractive index higher than a refractive index of the first semiconductor layer, and forming an active layer opposite to the first semiconductor layer with respect to the photonic crystal layer. The photonic crystal layer has a first region and a plurality of second regions each having a refractive index different from a refractive index of the first region and periodically disposed in the first region in a plane of the photonic crystal layer. The second regions extend from the photonic crystal layer to the first semiconductor layer.

### [Effects of the Invention]

According to the present disclosure, it is possible to provide a photonic-crystal surface emitting laser capable of suppressing deterioration of characteristics and a method of manufacturing the photonic-crystal surface emitting laser.

### BRIEF DESCRIPTION OF THE DRAWINGS

FIG. 1 is a cross-sectional view illustrating a photonic-crystal surface emitting laser according to a first embodiment.
FIG. 2A is a top view illustrating the photonic-crystal surface emitting laser.
FIG. 2B is a bottom view illustrating the photonic-crystal surface emitting laser.
FIG. 3 is an enlarged cross-sectional view of the photonic-crystal surface emitting laser.
FIG. 4A is a plan view of a photonic crystal layer.
FIG. 4B is an enlarged view of the photonic crystal layer.
FIG. 5 is a diagram illustrating a coupling coefficient.
FIG. 6A is a cross-sectional view illustrating a method of manufacturing the photonic-crystal surface emitting laser.
FIG. 6B is a top view illustrating a method of manufacturing the photonic-crystal surface emitting laser.
FIG. 7A is a cross-sectional view illustrating a method of manufacturing the photonic-crystal surface emitting laser.
FIG. 7B is a top view illustrating a method of manufacturing the photonic-crystal surface emitting laser.
FIG. 8A is a cross-sectional view illustrating a method of manufacturing the photonic-crystal surface emitting laser.
FIG. 8B is a top view illustrating a method of manufacturing the photonic-crystal surface emitting laser.
FIG. 9A is a cross-sectional view illustrating a method of manufacturing the photonic-crystal surface emitting laser.
FIG. 9B is a top view illustrating a method of manufacturing the photonic-crystal surface emitting laser.
FIG. 10A is a cross-sectional view illustrating a method of manufacturing the photonic-crystal surface emitting laser.
FIG. 10B is a top view illustrating a method of manufacturing the photonic-crystal surface emitting laser.
FIG. 11 is a cross-sectional view illustrating a method of manufacturing the photonic-crystal surface emitting laser.
FIG. 12 is a cross-sectional view illustrating a photonic-crystal surface emitting laser according to a second embodiment.
FIG. 13 is a diagram illustrating electric field strength.
FIG. 14 is a cross-sectional view illustrating a photonic-crystal surface emitting laser according to a third embodiment.
FIG. 15 is a cross-sectional view illustrating a photonic-crystal surface emitting laser according to a fourth embodiment.
FIG. 16A is a plan view illustrating a photonic crystal layer of a photonic-crystal surface emitting laser according to a fifth embodiment.
FIG. 16B is a plan view illustrating the photonic crystal layer of the photonic-crystal surface emitting laser according to a fifth embodiment.
FIG. 17 is a diagram illustrating a coupling coefficient.

### DETAILED DESCRIPTION

### DESCRIPTION OF EMBODIMENTS OF THE PRESENT DISCLOSURE

First, the contents of embodiments of the present disclosure will be listed and explained.
(1) A photonic-crystal surface emitting laser according to an aspect of the present disclosure includes a first semiconductor layer, a photonic crystal layer having a refractive index higher than a refractive index of the first semiconductor layer and provided on the first semiconductor layer, and an active layer provided opposite to the first semiconductor layer with respect to the photonic crystal layer. The photonic crystal layer has a first region and a plurality of second regions each having a refractive index different from a refractive index of the first region and periodically disposed in the first region in a plane of the photonic crystal layer. The second regions extend from the photonic crystal layer to the first semiconductor layer. It is possible to increase the coupling coefficient of the photonic crystal layer and deterioration of characteristics can be suppressed.
(2) The second regions may be holes extending from the photonic crystal layer to the first semiconductor layer. It is possible to increase the coupling coefficient and deterioration of characteristics can be suppressed.
(3) The second regions may be disposed in a square lattice in the plane of the photonic crystal layer. A depth of each second region may be greater than or equal to a lattice constant of the square lattice. It is possible to increase the coupling coefficient and deterioration of characteristics can be suppressed.
(4) The second regions may include a plurality of first holes and a plurality of second holes. At least one of the plurality of first holes and the plurality of second holes may extend from the photonic crystal layer to the first semiconductor layer. It is possible to increase the coupling coefficient and deterioration of characteristics can be suppressed.
(5) The first holes and the second holes may extend from the photonic crystal layer to the first semiconductor layer. It is possible to increase the coupling coefficient and deterioration of characteristics can be suppressed.
(6) The plurality of first holes and the plurality of second holes may be disposed in a square lattice in a plane of the photonic crystal layer. A ratio d/a between a distance d between the first holes and the second holes and a lattice constant a of the square lattice may be 0.35 to 0.45. It is possible to increase the coupling coefficient and deterioration of characteristics can be suppressed.
(7) The plurality of first holes and the plurality of second holes may be disposed in a square lattice in a plane of the photonic crystal layer. A depth of each first hole and a depth of each second hole may be greater than or equal to a lattice constant of the square lattice. It is possible to increase the coupling coefficient and deterioration of characteristics can be suppressed.
(8) An area of each second hole in a plane of the photonic crystal layer may be larger than an area of each first hole. The second holes may be deeper than the first holes. Light can be emitted in the normal direction.
(9) A shape of each first hole and a shape of each second hole in a plane of the photonic crystal layer may be circular or elliptical. It is possible to increase the coupling coefficient and deterioration of characteristics can be suppressed.
(10) The plurality of first holes and the plurality of second holes may be disposed in a square lattice in a plane of the photonic crystal layer. A depth of each first hole and a depth of each second hole may be 5 times a lattice constant of the square lattice or less. Increases in thermal resistance and electrical resistance can be suppressed.
(11) The photonic-crystal surface emitting laser may include a second semiconductor layer provided between the photonic crystal layer and the active layer. An end portion of each second region on a side of the active layer may be positioned at an interface between the photonic crystal layer and the second semiconductor layer. It is possible to increase the coupling coefficient and deterioration of characteristics can be suppressed.
(12) An end portion of each second region on a side of the active layer may be positioned closer to the first semiconductor layer than an interface between the photonic crystal layer and the active layer. It is possible to increase the coupling coefficient and deterioration of characteristics can be suppressed.
(13) The photonic-crystal surface emitting laser may include a p-type third semiconductor layer provided on the active layer. The first semiconductor layer and the photonic crystal layer may be n-type layers. Since the n-type photonic crystal layer includes the first region and the second region, the photonic crystal layer and the first semiconductor layer are less likely to be damaged, and a change in electric resistance is suppressed.
(14) The first semiconductor layer may contain indium phosphide. The first region of the photonic crystal layer may contain indium gallium arsenide phosphide. It is possible to increase the coupling coefficient and deterioration of characteristics can be suppressed.
(15) A method of manufacturing a photonic-crystal surface emitting laser includes forming a photonic crystal layer on a first semiconductor layer, the photonic crystal layer having a refractive index higher than a refractive index of the first semiconductor layer, and forming an active layer opposite to the first semiconductor layer with respect to the photonic crystal layer. The photonic crystal layer has a first region and a plurality of second regions each having a refractive index different from a refractive index of the first region and periodically disposed in the first region in a plane of the photonic crystal layer. The second regions extend from the photonic crystal layer to the first semiconductor layer. It is possible to increase the coupling coefficient of the photonic crystal layer and deterioration of characteristics can be suppressed.

### [Details of Embodiments of Present Disclosure]

Specific examples of a photonic-crystal surface emitting laser and a manufacturing method thereof according to embodiments of the present disclosure will be described below with reference to the drawings. The present disclosure is not limited to these examples, and is defined by the scope of the claims, and is intended to include all modifications within the meaning and scope equivalent to the scope of the claims.

### <first embodiment>

### (photonic-crystal surface emitting laser)

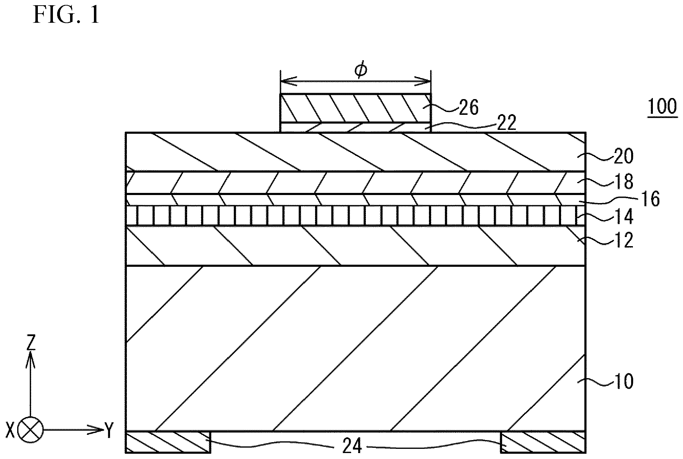

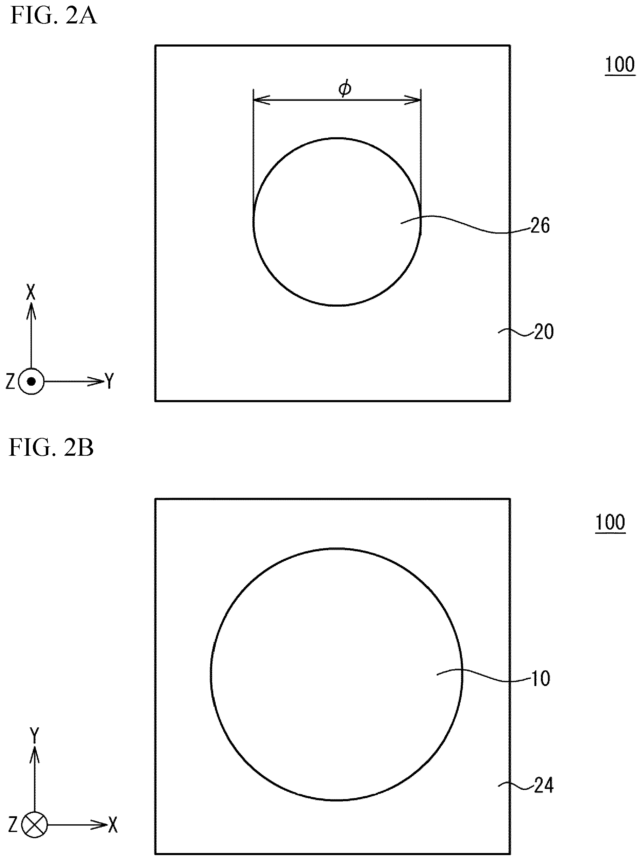

FIG. 1 is a cross-sectional view illustrating a photonic-crystal surface emitting laser 100 according to a first embodiment. FIG. 2A is a top view and FIG. 2B is a bottom view illustrating photonic-crystal surface emitting laser 100. As illustrated in FIG. 1, photonic-crystal surface emitting laser (PCSEL) 100 includes a substrate 10, a cladding layer 12 (first semiconductor layer), a photonic crystal layer 14, a cladding layer 16 (second semiconductor layer), an active layer 18, a cladding layer 20, and a contact layer 22, which are stacked in this order. The Z-axis direction is a stacking direction of layers. Each layer extends in the XY-plane. The X-axis direction, the Y-axis direction, and the Z-axis direction are orthogonal to each other.

Contact layer 22 is circular in the XY-plane and is positioned at a central portion of an upper surface of cladding layer 20. An electrode 26 is a p-type electrode provided on an upper surface of contact layer 22, and may be made of, for example, titanium (Ti), platinum (Pt), gold (Au), or other metals. As illustrated in FIG. 2A, electrode 26 is circular and is positioned at the central portion of the upper surface of cladding layer 20. A diameter of electrode 26 is represented by ϕ. An electrode 24 is an n-type electrode and may be formed of, for example, gold (Au), germanium (Ge), nickel (Ni), or another metal. As illustrated in FIG. 2B, electrode 24 is provided at a peripheral portion of a lower surface of substrate 10, and a portion surrounded by electrodes 24 functions as a light emitting portion (aperture). An aperture may be provided on an upper surface of photonic-crystal surface emitting laser 100.

Substrate 10 and cladding layers 12 and 16 are formed of, for example, n-type indium phosphide (n-InP). Cladding layer 20 is formed of, for example, p-InP. Contact layer 22 is formed of, for example, p-type indium gallium arsenide (p-InGaAs). An n-type dopant is, for example, silicon (Si). A p-type dopant is, for example, zinc (Zn). Photonic crystal layer 14 is formed of, for example, n-type indium gallium arsenide phosphide (InGaAsP). Active layer 18 includes a plurality of well layers and barrier layers formed of, for example, undoped indium gallium arsenide phosphide (InGaAsP) or aluminum gallium indium arsenide (AlGaInAs), and has a Multi-Quantum Well (MQW) structure. The above materials are examples, and each layer may be formed of other materials or a combination of the above materials and other materials. The thickness of each layer will be described later.

A refractive index of active layer 18 is, for example, 3.5. Refractive indices of cladding layers 12, 16 and 20 are, for example, 3.2. A refractive index of InGaAsP, which is a base material of photonic crystal layer 14, is higher than the refractive indices of cladding layers 12, 16 and 20 and is, for example, 3.4.

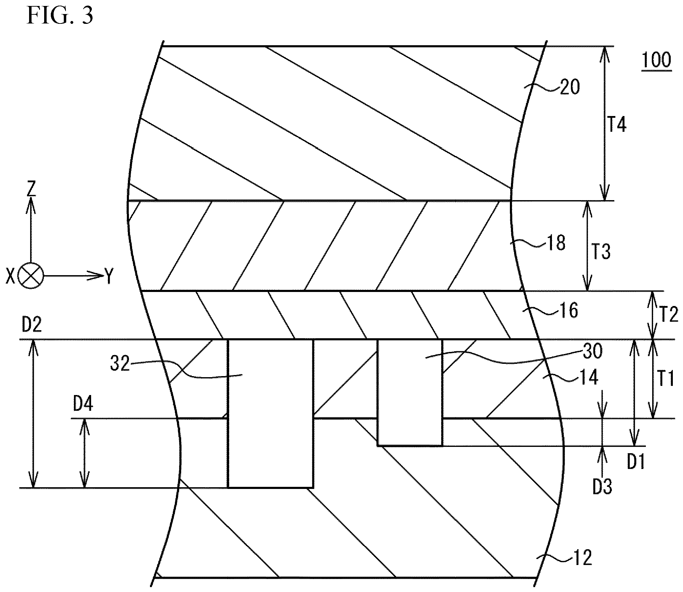

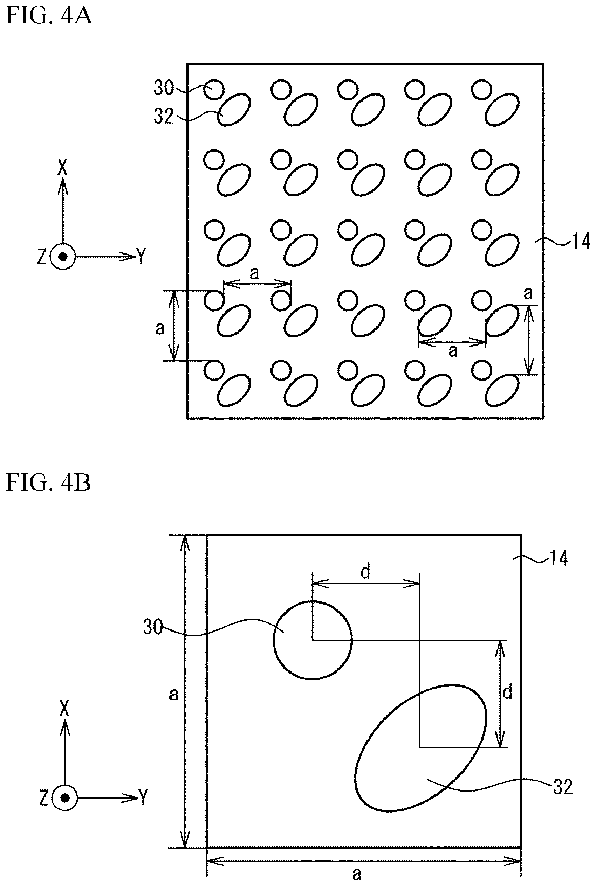

FIG. 3 is an enlarged cross-sectional view of photonic-crystal surface emitting laser 100, and illustrating cladding layer 12 through cladding layer 20. FIG. 4A is a plan view of photonic crystal layer 14. FIG. 4B is an enlarged view of photonic crystal layer 14. As illustrated in FIGS. 3 to 4B, photonic crystal layer 14 is a two dimensional photonic crystal layer having holes 30 (first holes) and holes 32 (second holes). As illustrated in FIG. 3, holes 30 and 32 penetrate photonic crystal layer 14 in the Z-axis direction and extend to cladding layer 12. Bottom surfaces of holes 30 and 32 are formed in cladding layer 12. An end portion of each of holes 30 and 32 near active layer 18 is positioned at an interface between photonic crystal layer 14 and cladding layer 16. A depth D2 of hole 32 is greater than a depth D1 of hole 30.

Each inside of holes 30 and 32 is hollow. The refractive index of InGaAsP which is the base material of photonic crystal layer 14 is different from the refractive indices of holes 30 and 32. That is, photonic crystal layer 14 includes InGaAsP (first region) as a base material and holes 30 and 32 (second regions) each having a refractive index different from that of the base material.

As illustrated in FIG. 4A, a plurality of holes 30 and a plurality of holes 32 are periodically arranged in the X-axis direction and the Y-axis direction in a plane of photonic crystal layer 14 and are disposed in a square lattice. The period of each of holes 30 and 32 in the X-axis direction and the Y-axis direction is a. The period a is equal to a ratio λ/n between the wavelength λ of the light and an effective refractive index n. For example, when λ = 1.3 µm and n = 3.25, a = 0.4 µm.

FIG. 4B is an enlarged view of a square (a square lattice) of photonic crystal layer 14 having a side length of a and including one hole 30 and one hole 32 therein. That is, the lattice constant of the square lattice is a. The direction in which hole 30 and hole 32 are arranged is inclined by, for example, 45° with respect to the X-axis direction and the Y-axis direction. The planar shape of hole 30 is, for example, circular. The planar shape of hole 32 is, for example, elliptical. The major axis and the minor axis of hole 32 are inclined by, for example, 45° with respect to the X-axis direction and the Y-axis direction. A ratio (area filling ratio) of an area occupied by hole 30 to an area a² of unit square lattice is, for example, 4%, and the area filling ratio of hole 32 is, for example, 8%. A distance between a centroid (center) of hole 30 and a centroid (center) of hole 32 in the X-axis direction and the Y-axis direction is d. As will be described later, the distance d is determined based on the lattice constant a.

A thickness of each layer and the depth of each hole are also determined based on the lattice constant a. The thicknesses T2 of cladding layer 16 and T3 of active layer 18 are each for example 0.25a, and the thickness T4 of cladding layer 20 is for example 7.5a. The thickness T1 of photonic crystal layer 14 is, for example, a or more. A depth D3 of hole 30 protruding into cladding layer 12 is, for example, 0.25a, and the total depth D1 of hole 30 is, for example, 1.25a or more. The depth D4 of hole 32 protruding into cladding layer 12 is, for example, 0.75a, and the total depth D2 of hole 32 is, for example, 1.75a or more. When a = 0.4 µm, the depth D1 is 0.5 µm or more, and the depth D2 is 0.7 µm or more.

Applying voltage to electrodes 24 and 26 and injecting current into active layer 18 allow active layer 18 to generate light. Since photonic crystal layer 14 has the plurality of holes 30 and 32 disposed periodically, the refractive index also changes periodically. Light undergoes diffraction, interference, and the like according to a change in refractive index in photonic crystal layer 14. Light having a wavelength corresponding to the period of the holes of photonic crystal layer 14 is amplified and emitted in the normal direction (Z-axis direction) of photonic crystal layer 14. In the example of FIG. 1, the lower surface of electrode 26 is mirror-finished to reflect light downward. The portion surrounded by electrode 24 in substrate 10 illustrated in FIG. 2B becomes the light emitting portion (aperture), and light is emitted from the aperture.

In order to reduce power consumption, it is important to reduce the size of photonic-crystal surface emitting laser 100 and to reduce the threshold current. However, there is a possibility that the characteristics are deteriorated by the reduction of the size. In the first embodiment, it is possible to improve the in-a-plane coupling coefficient of photonic crystal layer 14 and to suppress deterioration of characteristics.

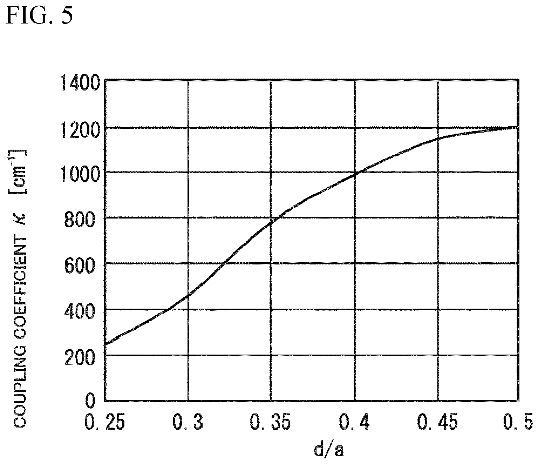

FIG. 5 illustrates the coupling coefficient. A horizontal axis represents a ratio d/a between the distance d between the centroids of holes 30 and 32 and the lattice constant a. A vertical axis represents a coupling coefficient κ. The thickness T1 of photonic crystal layer 14 illustrated in FIG. 3 and the lattice constant a illustrated in FIG. 4B are each, for example, 0.4 µm. The area filling ratio of hole 30 with respect to the area a² of the square lattice is 4%, and the area filling ratio of hole 32 is 8%.

As the ratio d/a increases, the coupling coefficient κ increases. When the ratio is 0.35 or more, the coupling coefficient κ increases to 800 cm⁻¹ or more. When the ratio is 0.4 or more, the coupling coefficient κ is 1000 cm⁻¹ or more. When the ratio is 0.5, the coupling coefficient κ reaches 1200 cm⁻¹.

As described above, the lattice constant a is determined by the wavelength λ and the effective refractive index n, and is equal to the ratio λ/n. As illustrated in FIG. 5, the coupling coefficient varies according to the ratio d/a between the distance d and the lattice constant a. Therefore, the distance d can be determined so that the coupling coefficient becomes high. For example, when the distance d is set to 0.35a or more, the coupling coefficient κ becomes about 800 cm⁻¹ or more. When the distance d approaches 0.5a, scattering of light from photonic crystal layer 14 is reduced, and thus the optical output is reduced. The distance d is set to be 0.5a or less, such as 0.45a or less.

### (Manufacturing Method)

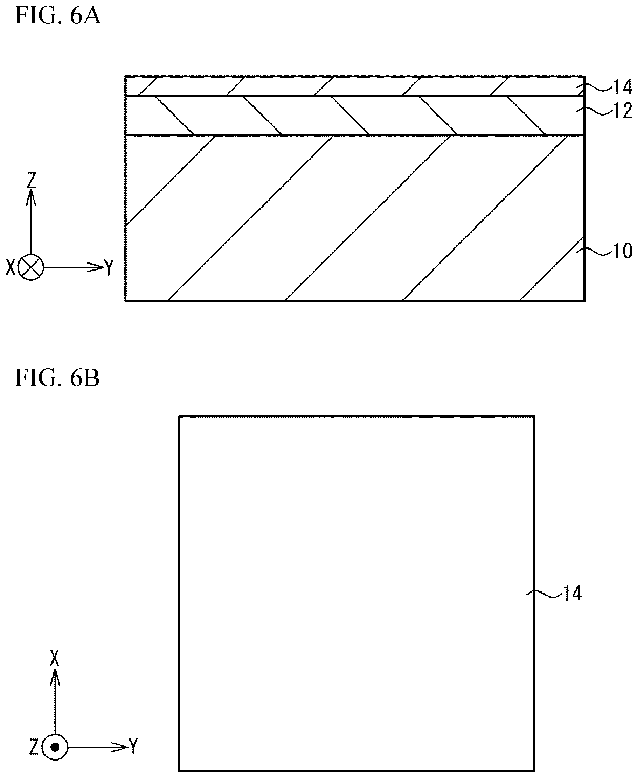

FIGS. 6A, 7A, 8A, 9A, 10A, and 11 are cross-sectional views illustrating a method of manufacturing photonic-crystal surface emitting laser 100. FIGS. 6B, 7B, 8B, 9B, and 10B are top views illustrating a method of manufacturing photonic-crystal surface emitting laser 100.

As illustrated in FIGS. 6A and 6B, cladding layer 12 and photonic crystal layer 14 are epitaxially grown in this order on the upper surface of substrate 10 by Organometallic Vapor Phase Epitaxy (OMVPE) method, for example.

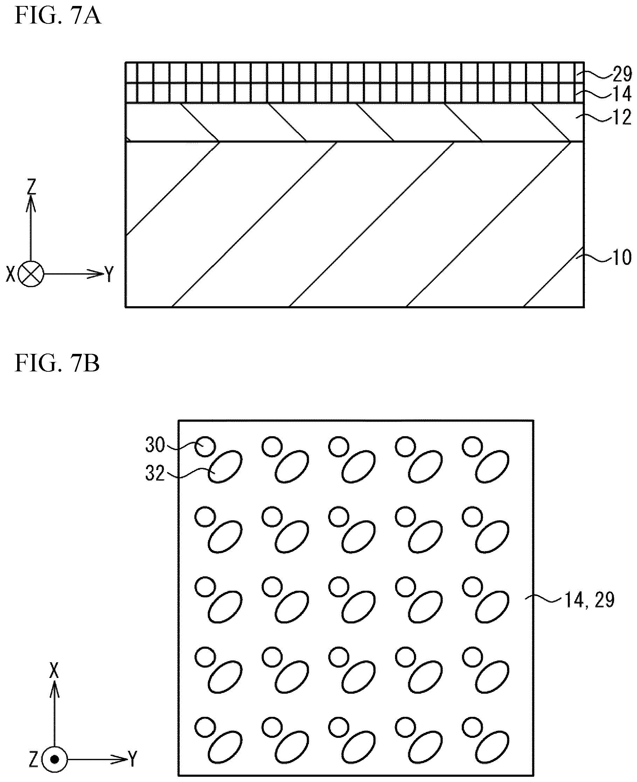

As illustrated in FIGS. 7A and 7B, the plurality of holes 30 and 32 are formed. A resist mask 29 is formed on the upper surface of photonic crystal layer 14 by photolithography. Resist mask 29 has openings corresponding to holes 30 and 32. Holes 30 and 32 are formed by dry etching photonic crystal layer 14. Etching proceeds faster in the larger openings corresponding to holes 32 and slower in the smaller openings corresponding to holes 30. Therefore, holes 30 and 32 can be formed by etching once. Holes 30 and 32 extend from the upper surface of photonic crystal layer 14 partway into cladding layer 12. After etching, resist mask 29 is removed.

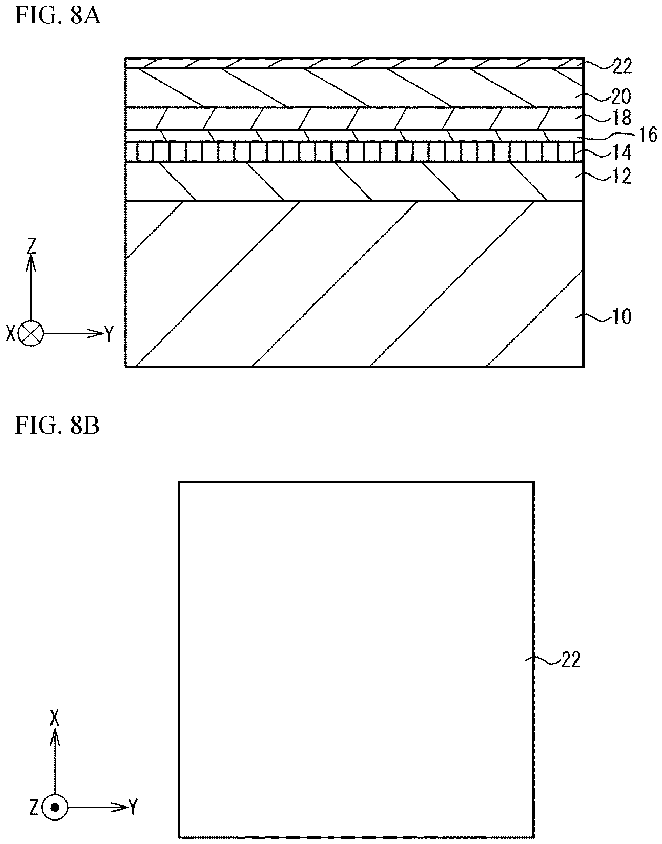

As illustrated in FIGS. 8A and 8B, cladding layer 16, active layer 18, cladding layer 20, and contact layer 22 are epitaxially grown in this order on photonic crystal layer 14 by OMVPE method or the like. Cladding layer 16 is in contact with the upper surface of photonic crystal layer 14 to form a planar surface. Active layer 18, cladding layer 20 and contact layer 22 are formed on the planar cladding layer 16. The insides of holes 30 or 32 are not filled with cladding layer 16 and remain hollow.

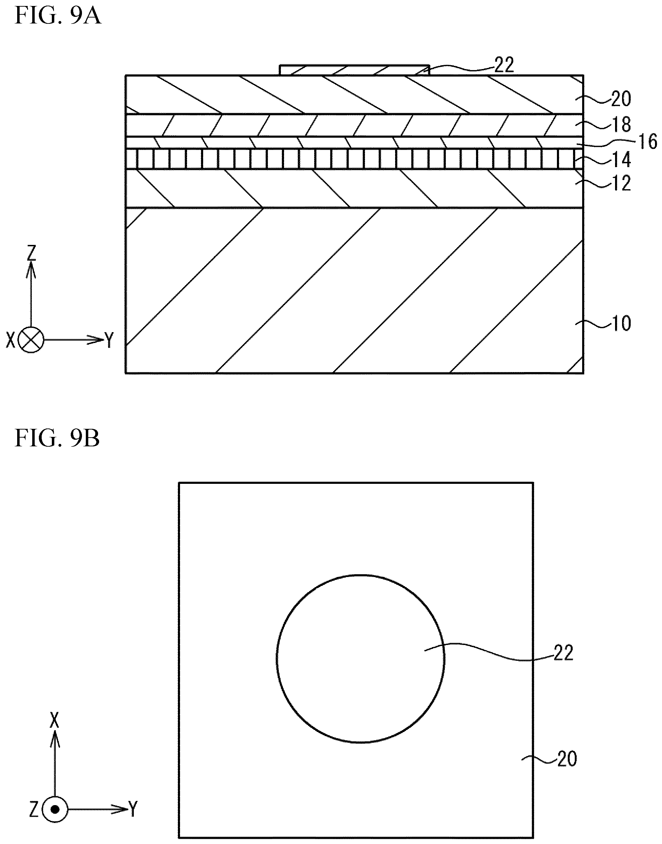

As illustrated in FIGS. 9A and 9B, contact layer 22 is formed to have a circular shape. For example, a resist mask having a circular shape (not illustrated) is formed on contact layer 22 by photolithography. A portion of contact layer 22 exposed from the resist mask is removed by dry etching or wet etching to form contact layer 22. After etching, cladding layer 20 is exposed outside contact layer 22. The resist mask is removed.

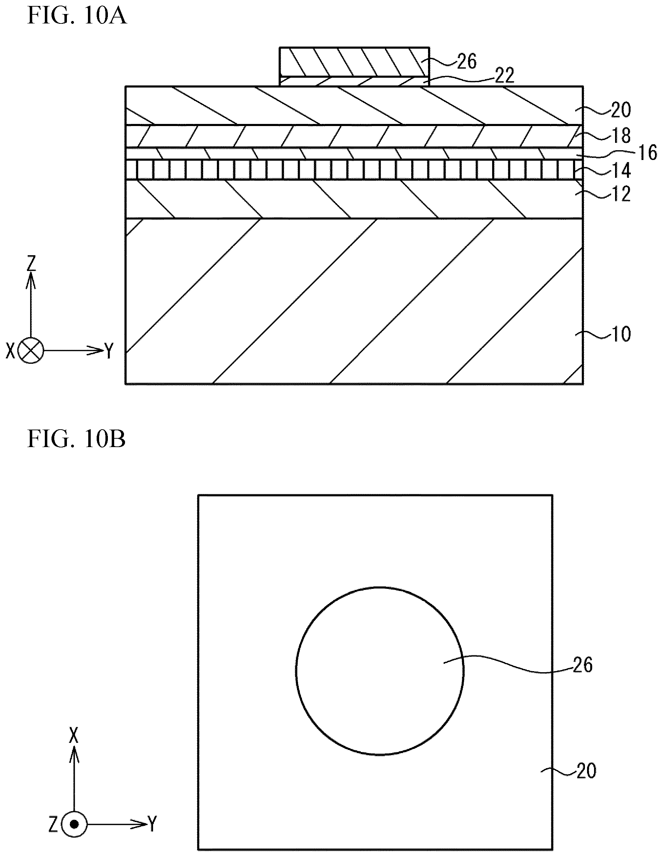

As illustrated in FIGS. 10A and 10B, electrode 26 is provided on the upper surface of contact layer 22. For example, a resist mask is provided by photolithography, and a metal layer is formed by vapor deposition or the like. The unnecessary metal layer is removed together with the resist mask, and electrode 26 is formed by the metal layer on contact layer 22. An insulating film may be provided on cladding layer 20, and a pad connected to electrode 26 may be provided on the insulating film.

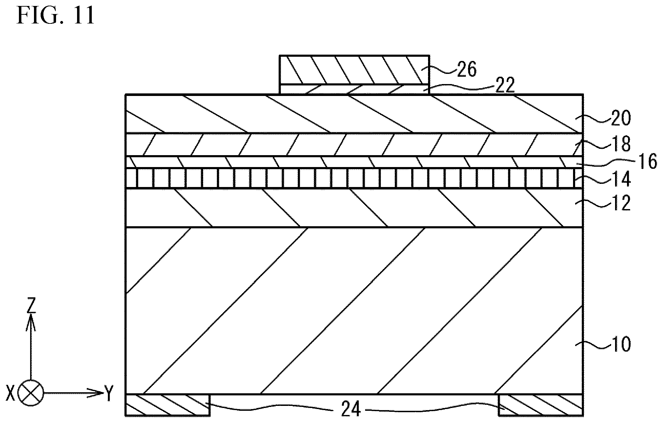

As illustrated in FIG. 11, electrode 24 is provided on the lower surface of substrate 10 by vapor deposition and lift-off or the like in the similar manner as electrode 26. Through the above steps, photonic-crystal surface emitting laser 100 is formed.

According to the first embodiment, as illustrated in FIG. 3, cladding layer 12 and photonic crystal layer 14 having a higher refractive index are stacked. Holes 30 and 32 in photonic crystal layer 14 extend from photonic crystal layer 14 to cladding layer 12. The coupling coefficient becomes high, and light is strongly diffracted by photonic crystal layer 14. Deterioration of characteristics such as threshold current and optical output can be suppressed. Reduction of size and excellent characteristics of photonic-crystal surface emitting laser 100 can be achieved. Power consumption can be reduced by the size reduction. For example, by reducing the diameter ϕ of electrode 26 illustrated in FIG. 1, the size of photonic-crystal surface emitting laser 100 can be reduced. Even when the diameter ϕ is reduced to 40 µm or less, for example, 20 µm, oscillation is possible.

As illustrated in FIG. 3, photonic crystal layer 14 has holes 30 and 32 each having a refractive index different from the refractive index of InGaAsP which is the base material. Both holes 30 and 32 extend through photonic crystal layer 14 to cladding layer 12. More specifically, one end of each of holes 30 and 32 is positioned at the interface between photonic crystal layer 14 and cladding layer 16, and the other end is positioned in cladding layer 12. Since the coupling coefficient is increased and light is strongly diffracted, deterioration of characteristics can be suppressed. As described in the second embodiment, the configuration of holes 30 and 32 may be changed. Photonic crystal layer 14 may have a region having a refractive index different from the refractive index of the base material instead of the hole.

As illustrated in FIG. 4A, the plurality of holes 30 and 32 are disposed in a square lattice in the XY plane. The ratio d/a of the distance d between the centroids of the holes and the lattice constant a illustrated in FIG. 4B is 0.35 to 0.45. By setting the ratio d/a in this range, the coupling coefficient can be increased as illustrated in FIG. 5, and photonic-crystal surface emitting laser 100 can be reduced in size and have good characteristics. The ratio d/a may be, for example, 0.35 or more, 0.4 or more, 0.5 or less, 0.55 or less, or the like.

The depth D1 of hole 30 is 1.25a or more, and the depth D2 of hole 32 is 1.75a or more. Since holes 30 and 32 are deep, the coupling coefficient can be increased, light can be strongly diffracted, and deterioration of characteristics can be suppressed. In order to improve the coupling coefficient, the depths of holes 30 and 32 are preferably equal to or greater than the lattice constant a. On the other hand, if holes 30 and 32 are too deep, the thermal resistance and electrical resistance will increase. This brings the temperature to rise, and the characteristics may deteriorate. As the electrical resistance increases, the power loss increases. The depths D1 and D2 are preferably 5 times the lattice constant a or less, for example. Increases in thermal resistance and electrical resistance can be suppressed.

As illustrated in FIG. 4A, the area of hole 32 in the plane of photonic crystal layer 14 is larger than the area of hole 30, and as illustrated in FIG. 3, hole 32 is deeper than hole 30. By providing two types of holes 30 and 32 having different sizes in photonic crystal layer 14, light can be extracted in the normal direction (Z-axis direction). As illustrated in FIGS. 7A and 7B, holes 30 and 32 can be formed simultaneously by providing resist mask 29 and performing dry etching in a single step. The process is simplified.

When sizes of holes 30 and 32 become larger, diffraction of light can be enhanced. On the other hand, as holes 30 and 32 become larger, an effective refractive index of photonic crystal layer 14 decreases, and light may leak into other layers. The area filling ratio of each of holes 30 and 32 with respect to the square lattice is, for example, 15% or less. The sum of the area filling ratio of hole 30 and the area filling ratio of hole 32 is, for example, 10% or more and 20% or less.

As illustrated in FIG. 4B, hole 30 is circular and hole 32 is elliptical. The direction in which hole 30 and hole 32 are aligned is inclined with respect to the X-axis direction and the Y-axis direction. This inclination enables light to be diffracted and emitted in the normal direction. Hole 30 may be elliptical and hole 32 may be circular. Hole 30 and hole 32 may have the similar shape, for example both may be circular or both may be elliptical. Holes 30 and 32 may be polygonal, for example triangular or square. The angle at which holes 30 and 32 are aligned with respect to the X-axis direction and the Y-axis direction may be other than 45°.

As illustrated in FIG. 3, photonic crystal layer 14, cladding layer 16 and active layer 18 are stacked in this order. Since active layer 18 does not exist in the step of forming holes 30 and 32 illustrated in FIGS. 4A and 4B, damage to active layer 18 due to etching does not occur. As illustrated in FIG. 8A, since active layer 18 is formed on the surface of cladding layer 16 which is flatter than that of photonic crystal layer 14, a depression or the like is less likely to occur in active layer 18. Photonic crystal layer 14 may be stacked on active layer 18. In such a case, the dry etching may proceed to active layer 18 in the step of forming holes 30 and 32 and may damage active layer 18. As illustrated in FIG. 3, by stacking active layer 18 above photonic crystal layer 14, the damage can be suppressed.

Photonic crystal layer 14 and cladding layer 12 may have damaged portion around each of holes 30 and 32. The damaged portion exhibits n-type characteristics. Since photonic crystal layer 14 and cladding layer 12 are n-type layers, the electrical resistance is unlikely to increase even if the damage occurs. Photonic crystal layer 14 and cladding layer 12 may be p-type layers. However, as described above, damage may occur around holes 30 and 32. When damage exhibiting n-type characteristics occurs in the p-type layer, the electrical resistance increases. When photonic crystal layer 14 and cladding layer 12 are n-type layers, an increase in electric resistance can be suppressed.

Cladding layer 12 is formed of n-InP. Photonic crystal layer 14 is formed of InGaAsP and has a refractive index higher than that of cladding layer 12. By providing holes 30 and 32 in these two layers, the coupling coefficient can be increased. Substrate 10, cladding layers 12, 16, and 20, photonic crystal layer 14, active layer 18, and contact layer 22 may be formed of compound semiconductors other than those described above. Photonic crystal layer 14 may be formed of, for example, n-type aluminum gallium indium arsenide (n-AlGaInAs).

For example, substrate 10 and photonic crystal layer 14 may be formed of n-type gallium arsenide (n-GaAs), and cladding layers 12 and 16 may be formed of n-AlGaAs. Cladding layer 20 may be formed of p-AlGaAs and contact layer 22 may be formed of p-GaAs. Active layer 18 may be formed of a stacked structure of InGaAs/AlGaAs or AlGaInAs.

### <second embodiment>

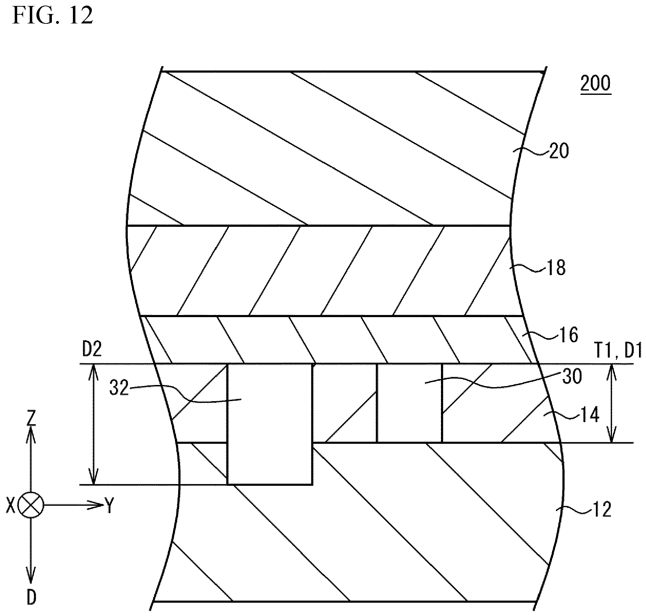

FIG. 12 is a cross-sectional view illustrating a photonic-crystal surface emitting laser 200 according to a second embodiment, and is an enlarged view similar to FIG. 3. Description of the same configuration as that of the first embodiment will be omitted. A D-axis direction in FIG. 12 is opposite to the Z-axis direction. As illustrated in FIG. 12, a lower end of hole 30 is positioned at the interface between cladding layer 12 and photonic crystal layer 14. The depth D1 of hole 30 is equal to the thickness T1 of photonic crystal layer 14. The depth D2 of hole 32 is larger than the thickness T1 by, for example, 0.5a.

In the second embodiment, holes 30 penetrate through photonic crystal layer 14. Holes 32 extend from photonic crystal layer 14 into cladding layer 12. As in the first embodiment, since the coupling coefficient is increased, it is possible to suppress deterioration of the characteristics of photonic-crystal surface emitting laser 200. Photonic-crystal surface emitting laser 200 can be reduced in size and have excellent characteristics.

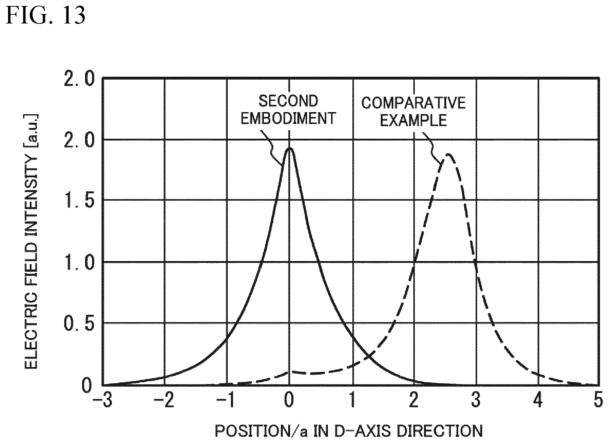

FIG. 13 is a diagram illustrating electric field strength. A horizontal axis represents the position in the normal direction and is normalized by the lattice constant a. Zero on the horizontal axis corresponds to the center of active layer 18, a positive value is a position in the D-axis direction (position toward substrate 10), and a negative value is a position in the Z-axis direction (position toward cladding layer 20). A vertical axis is an electric field intensity. A dashed line is the calculation result of the electric field strength of a comparative example, and a solid line is the calculation result of the second embodiment.

In the comparative example, none of holes 30 and 32 penetrate photonic crystal layer 14, and their lower ends are positioned above the interface between photonic crystal layer 14 and cladding layer 12. As indicated by the dashed line in FIG. 13, the optical confinement in photonic crystal layer 14 having a high refractive index is strong, and the optical confinement in active layer 18 is weak.

On the other hand, in the second embodiment, holes 30 and 32 penetrate photonic crystal layer 14. Compared to the comparative example, the optical confinement in photonic crystal layer 14 is weak, and the optical confinement in active layer 18 is strong. Characteristics such as threshold current and optical output are improved.

### <Third Embodiment>

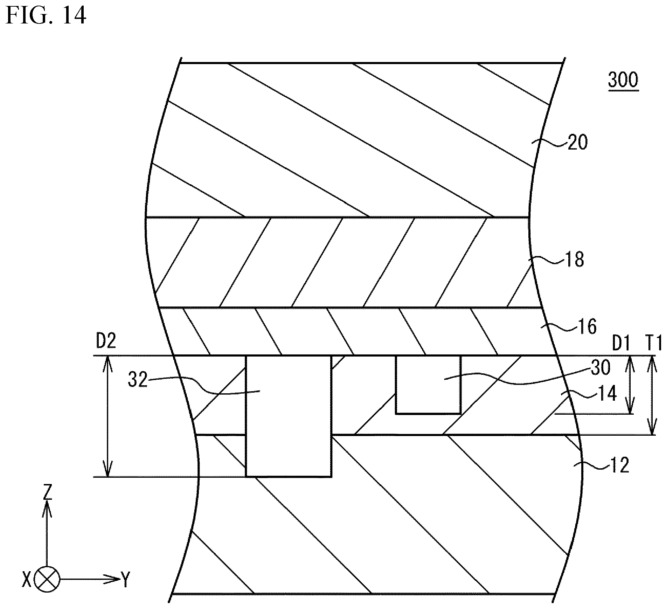

FIG. 14 is a cross-sectional view illustrating a photonic-crystal surface emitting laser 300 according to a third embodiment, and is an enlarged view similar to FIG. 3. Description of the same configuration as that of the first embodiment will be omitted. As illustrated in FIG. 14, hole 30 does not penetrate photonic crystal layer 14 and does not reach cladding layer 12. A lower end of hole 30 is located in photonic crystal layer 14, and photonic crystal layer 14 forms a bottom surface. Hole 32 penetrates through photonic crystal layer 14 and reaches cladding layer 12. The depth D1 of hole 30 is smaller than the thickness T1 of photonic crystal layer 14 by, for example, 0.25a. The depth D2 of hole 32 is larger than the thickness T1 by, for example, 0.5a.

According to the third embodiment, since the coupling coefficient is increased by extending hole 32 from photonic crystal layer 14 to cladding layer 12, it is possible to suppress deterioration of the characteristics of photonic-crystal surface emitting laser 300. Photonic-crystal surface emitting laser 300 can be reduced in size and have excellent characteristics.

### <Fourth Embodiment>

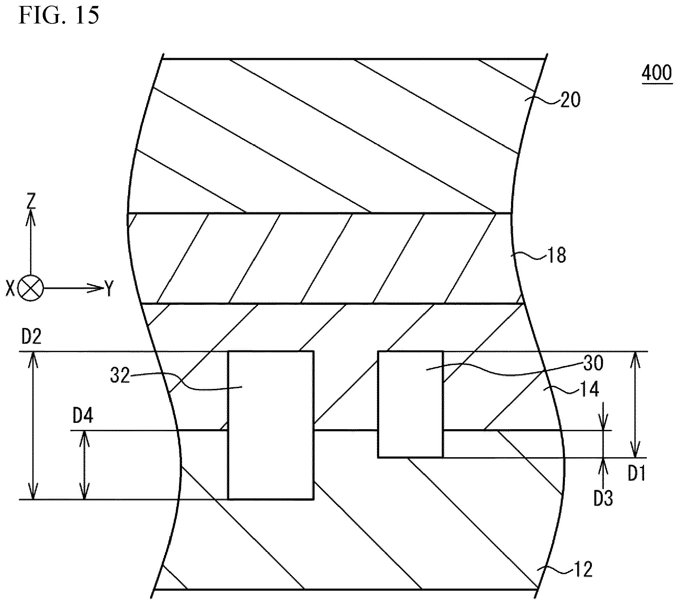

FIG. 15 is a cross-sectional view illustrating a photonic-crystal surface emitting laser 400 according to a fourth embodiment and is an enlarged view similar to FIG. 3. Description of the same configuration as that of the first embodiment will be omitted.

As illustrated in FIG. 15, photonic-crystal surface emitting laser 400 does not have cladding layer 16. Active layer 18 is stacked on the upper surface of photonic crystal layer 14. The thickness T1 of photonic crystal layer 14 is greater than, for example, the lattice constant a. Holes 30 and 32 do not penetrate from the upper surface to the bottom surface of photonic crystal layer 14. Upper ends of holes 30 and 32 are positioned in photonic crystal layer 14. Photonic crystal layer 14 blocks up the upper ends of holes 30 and 32. The lower ends of holes 30 and 32 are positioned in cladding layer 12. The depths of holes 30 and 32 are, for example, the same as those of the first embodiment. The depth D1 of hole 30 is, for example, 1.25a, and an amount D3 of protrusion from the lower surface of photonic crystal layer 14 is, for example, 0.25a. The depth D2 of hole 32 is, for example, 1.75a, and a protrusion amount D4 is, for example, 0.75a.

Substrate 10 and photonic crystal layer 14 are formed of, for example, n-type gallium nitride (n-GaN). Cladding layer 12 is formed of, for example, n-type aluminum gallium nitride (n-AlGaN). Cladding layer 20 is formed of, for example, p-AlGaN, and contact layer 22 is formed of, for example, p-GaN. Active layer 18 is formed of, for example, indium gallium nitride (InGaN).

According to the fourth embodiment, holes 30 and 32 extend from photonic crystal layer 14 to cladding layer 12. Since the coupling coefficient is increased, it is possible to suppress deterioration of characteristics of photonic-crystal surface emitting laser 400. Photonic-crystal surface emitting laser 400 can be reduced in size and have excellent characteristics. As in the first to fourth embodiments, at least one of the two types of holes 30 and 32 may extend from photonic crystal layer 14 to cladding layer 12.

### <Fifth Embodiment>

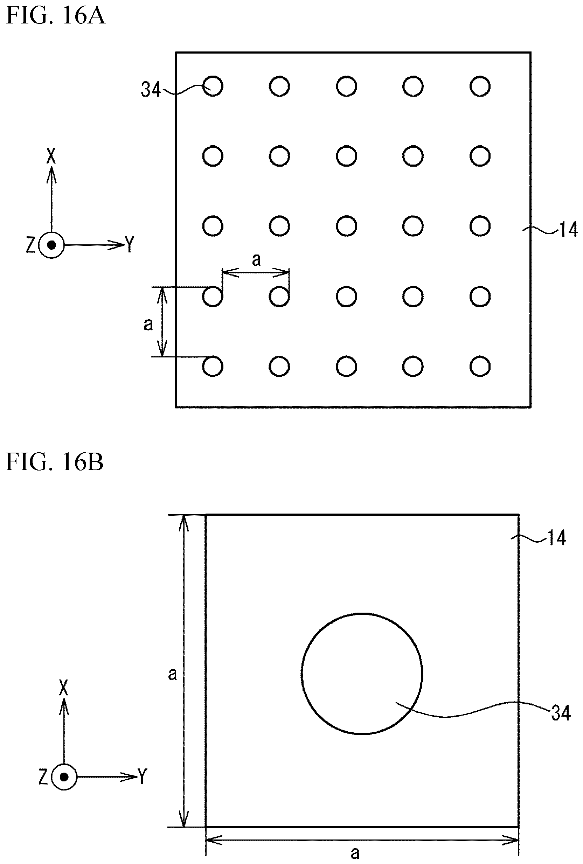

FIGS. 16A and 16B are plan views illustrating photonic crystal layer 14 of the photonic-crystal surface emitting laser according to a fifth embodiment. FIG. 16B is an enlarged view of unit square lattice similar to FIG. 4B. Description of the same configuration as that of the first embodiment will be omitted. As illustrated in FIGS. 16A and 16B, photonic crystal layer 14 has a single type of hole 34. The planar shape of hole 34 is, for example, circular, but may be elliptical or the like. As illustrated in FIG. 16A, a plurality of holes 34 are arranged at a period a in the X-axis direction and the Y-axis direction. The area filling ratio of hole 34 to the square lattice is, for example, 12%. Holes 34 extends through photonic crystal layer 14 to cladding layer 12, similar to holes 30 and 32 of FIG. 3.

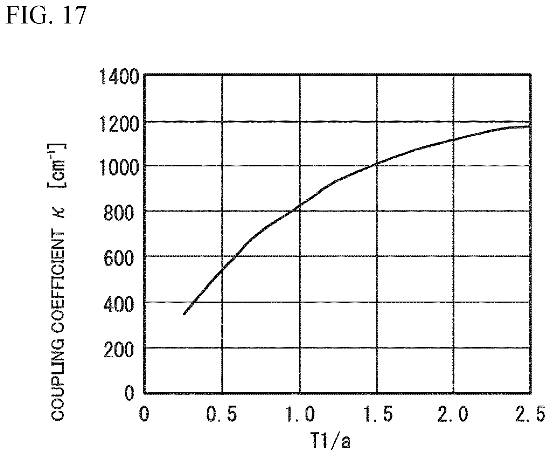

FIG. 17 is a diagram illustrating the coupling coefficient. A horizontal axis represents a ratio T1/a of the thickness T1 of photonic crystal layer 14 to the lattice constant a. A vertical axis represents a coupling coefficient κ. The larger the ratio, the higher the coupling coefficient. When the ratio is 1 or more, the coupling coefficient is 800 cm⁻¹ or more. As illustrated in FIG. 17, in order to increase the coupling coefficient, it is preferable that the thickness T1 is equal to or larger than the lattice constant a.

According to the fifth embodiment, similarly to the first embodiment, it is possible to suppress deterioration of the characteristics of the photonic-crystal surface emitting laser. Both reduction of size and excellent characteristics of a photonic-crystal surface emitting laser are achieved.

Although the embodiments of the present disclosure have been described in detail above, the present disclosure is not limited to the specific embodiments, and various modifications and changes can be made within the scope of the gist of the present disclosure described in the claims.

### REFERENCE SIGNS LIST

10 substrate
12, 16, 20 cladding layer
14 photonic crystal layer
18 active layer
22 contact layer
24, 26 electrode
29 resist mask
30, 32, 34 hole
100, 200, 300, 400 photonic-crystal surface emitting laser

## Claims

1. A photonic-crystal surface emitting laser comprising:
a first semiconductor layer;
a photonic crystal layer having a refractive index higher than a refractive index of the first semiconductor layer and provided on the first semiconductor layer; and
an active layer provided opposite to the first semiconductor layer with respect to the photonic crystal layer;
wherein the photonic crystal layer has a first region and a plurality of second regions each having a refractive index different from a refractive index of the first region and periodically disposed in the first region in a plane of the photonic crystal layer, and
wherein the second regions extend from the photonic crystal layer to the first semiconductor layer.

2. The photonic-crystal surface emitting laser according to claim 1, wherein the second regions are holes extending from the photonic crystal layer to the first semiconductor layer.

3. The photonic-crystal surface emitting laser according to claim 1 or claim 2, wherein the second regions are disposed in a square lattice in a plane of the photonic crystal layer, and
wherein a depth of each second region is greater than or equal to a lattice constant of the square lattice.

4. The photonic-crystal surface emitting laser according to any one of claims 1 to 3, wherein the second regions include a plurality of first holes and a plurality of second holes, and
wherein at least one of the plurality of first holes and the plurality of second holes extends from the photonic crystal layer to the first semiconductor layer.

5. The photonic-crystal surface emitting laser according to claim 4, wherein the first holes and the second holes extend from the photonic crystal layer to the first semiconductor layer.

6. The photonic-crystal surface emitting laser according to claim 4 or claim 5, wherein the plurality of first holes and the plurality of second holes are disposed in a square lattice in a plane of the photonic crystal layer, and
wherein a ratio d/a between a distance d between the first hole and the second hole and a lattice constant a of the square lattice is 0.35 to 0.45.

7. The photonic-crystal surface emitting laser according to any one of claims 4 to 6, wherein the plurality of first holes and the plurality of second holes are disposed in a square lattice in a plane of the photonic crystal layer, and
wherein a depth of each first hole and a depth of each second hole are greater than or equal to a lattice constant of the square lattice.

8. The photonic-crystal surface emitting laser according to any one of claims 4 to 7, wherein an area of each second hole in a plane of the photonic crystal layer is larger than an area of each first hole, and
wherein the second holes are deeper than the first holes.

9. The photonic-crystal surface emitting laser according to any one of claims 4 to 8, wherein a shape of each first hole and a shape of each second hole in a plane of the photonic crystal layer are circular or elliptical.

10. The photonic-crystal surface emitting laser according to any one of claims 4 to 9, wherein the plurality of first holes and the plurality of second holes are disposed in a square lattice in a plane of the photonic crystal layer, and
wherein a depth of each first hole and a depth of each second hole are 5 times a lattice constant of the square lattice or less.

11. The photonic-crystal surface emitting laser according to any one of claims 1 to 10, comprising:
a second semiconductor layer provided between the photonic crystal layer and the active layer,
wherein an end portion of each second region on a side of the active layer is positioned at an interface between the photonic crystal layer and the second semiconductor layer.

12. The photonic-crystal surface emitting laser according to any one of claims 1 to 10, wherein an end portion of each second region on a side of the active layer is positioned closer to the first semiconductor layer than an interface between the photonic crystal layer and the active layer.

13. The photonic-crystal surface emitting laser according to any one of claims 1 to 12, comprising:
a p-type third semiconductor layer provided on the active layer,
wherein the first semiconductor layer and the photonic crystal layer are n-type layers.

14. The photonic-crystal surface emitting laser according to any one of claims 1 to 13, wherein the first semiconductor layer contains indium phosphide, and
wherein the first region of the photonic crystal layer contains indium gallium arsenide phosphide.

15. A method of manufacturing a photonic-crystal surface emitting laser, the method comprising:
forming a photonic crystal layer on a first semiconductor layer, the photonic crystal layer having a refractive index higher than a refractive index of the first semiconductor layer; and
forming an active layer opposite to the first semiconductor layer with respect to the photonic crystal layer,
wherein the photonic crystal layer has a first region and a plurality of second regions each having a refractive index different from a refractive index of the first region and periodically disposed in the first region in a plane of the photonic crystal layer, and
wherein the second regions extend from the photonic crystal layer to the first semiconductor layer.
